Europäisches Patentamt

European Patent Office

Office européen des brevets

(11) Publication number: **0 180 361**
**B1**

# EUROPEAN PATENT SPECIFICATION

(45) Date of publication of patent specification: **28.12.88**

(51) Int. Cl.⁴: **F 16 D 17/00, C 23 C 14/50**

(21) Application number: **85307327.8**

(22) Date of filing: **14.10.85**

(54) Colleting spindle assembly.

(30) Priority: **16.10.84 US 661544**

(43) Date of publication of application:
**07.05.86 Bulletin 86/19**

(45) Publication of the grant of the patent:
**28.12.88 Bulletin 88/52**

(84) Designated Contracting States:
**DE FR GB**

(56) References cited:
**FR-A-1 236 680**
**FR-A-2 358 945**
**GB-A-1 076 814**
**US-A-4 002 141**
**US-A-4 037 804**
**US-A-4 398 733**

(73) Proprietor: **Hewlett-Packard Company**
**Mail Stop 20 B-O 3000 Hanover Street**
**Palo Alto California 94304 (US)**

(72) Inventor: **Lawton, Robert J.**
**10303 Granger**
**Boise Idaho 83704 (US)**

(74) Representative: **Squibbs, Robert Francis**
**Hewlett-Packard Limited Nine Mile Ride**
**Wokingham Berkshire RG11 3LL (GB)**

Courier Press, Leamington Spa, England.

## Description

The present invention relates to a colleting spindle assembly for releasably engaging and coupling rotational motion to an element; in particular, but not exclusively, the present invention relates to such an assembly for engaging and rotating a substrate mounting chassis in a vacuum deposition chamber.

Ths use of cam-like devices to engage and lock a workpiece to a rotating shaft is well known. Once such device comprises a cylindrical plug, keyed in place to prevent independent rotation, sliding within a hole bored through a sleeve. The largest diameter of the conical head is slightly less than the diameter of the counterbore. Four pins slid freely within four equally-space holes drilled radially through the walls of the sleeve into the counter-bore. A clevis pin is threaded through the centre of the plug and extends the length of the sleeve. An operating lever with a forked end fits over and is coupled to the clevis pin and bears against the end of the sleeve with smaller diameter bore. A cam-like curvature is formed at the connecting end of the lever with the cam radius gradually increasing through ninety degrees of rotation.

To lock the sleeve within the bearing hole in a workpiece, the operating lever is pivoted through ninety degrees. This action draws the conical head of the plug into the counterbore and into contact with four of the pins extending radially through the wall of the sleeve. As the plug is drawn into the counterbore, the pins are forced radially outward and into a receiving groove in the bearing surface of the workpiece thereby locking the workpiece to the sleeve.

U.S. Patent No. 4,398,733, issued to Thomas C. Mosley, on May 13, 1981, discloses a jawed lathe chuck having means selectively operative for engaging either the outer surface of a workpiece or the inner surface of a workpiece. The chuck comprises a hub rotatably journalled in a jaw carrier, which, in turn, is rotatably journalled in a body. The carrier pivotably mounts a plurality of jaws having camming surfaces, and drive pins upstanding from the hub and body slideably engage the camming surfaces to move the jaws outwardly, to engage the inner surface of a workpiece, or inwardly, to engage the outer surface of a workpece. A screw carried in the jaw carrier is movable into the hub, to lock the hub and jaw carrier together, and movable into the body, to lock the body and the jaw carrier together to prevent relative rotation between the hub and the jaw carrier or between the jaw carrier and the body.

U.S. Patent No. 4,002,141, issued to Robert L. Shrader on January 11, 1977, discloses an assembly for lifting a substrate holder from its carrier platform and rotating the holder in a vacuum chamber during a substrate coating process. The assembly basically comprises a main assembly that is reciprocally movable in a vertical direction by an actuating piston and a sub-assembly that is movable with the main assembly. The sub-assembly comprises a permanent magnet and a second or auxiliary actuating piston for independently and reciprocally moving the magnet in a vertical direction with respect to the main assembly. When the magnet and substrate holder are coupled together, actuation of the main piston lifts the entire assembly together with the substrate holder, clear of the carrier platform.

For rotating the coupled magnet and holder during the coating process, the magnet which is independently rotatable within the assembly about its vertical axis, is connected by a spring belt transmission to exterior motive means through a suitable seal in the coating chamber wall.

A principle concern in high vacuum, elevated temperature, thick or thin film deposition systems is to minimize the sources of particles within the deposition chambers which contaminate the deposition process itself. Typically, a major source of particles results from actuation or frictional engagement of metal parts. Further, in the production of certain deposited-film parts, such as disc memory media, magnetic contamination cannot be tolerated.

It is an object of the present invention to provide a colleting spindle assembly having characteristics making it particularly suited for use in a vacuum deposition chamber.

According to the present invention, there is provided a colleting spindle assembly for releasably engaging and coupling rotational motion to an element, characterized in that the assemly comprises a rotatably-mounted first shaft provided both with an internal cavity extending through the first shaft substantially parallel to the centre line of the latter, and with a protrusion projecting out from a first end of the first shaft adjacent its periphery; a second shaft disposed within the cavity of the first shaft, the centerline of the second shaft being offset from the centerline of the first shaft; a bearing eccentrically-mounted at one end of the second shaft, the bearing extending out beyond said first end of the first shaft whereby to be jointly insertable with said protrusion into a concavity of said element, and rotational drive means fixedly attached to the second end of the first shaft, and coupled to the second shaft for rotating the latter relative to the first shaft whereby to vary the distance between the centerline of the eccentrically mounted bearing and the centreline of the first shaft in order to move the bearing and protrusion into and out of gripping engagement with the walls of the concavity of the element.

When the colleting spindle assembly is used in relation to a vacuum deposition chamber, the first and second shafts are arranged to extend horizontally through a wall of the chamber in vacuum sealing relation therewith, the ends of the shafts carrying the protrusion and bearing being disposed within the chamber while the other ends of the shafts lie outside the chamber. With this arrangement, the rotational drive means is disposed outside the chamber; similarly, rotation of the first shaft to rotate an element engaged by the assembly can also be effected by drive means disposed outside the chamber. Furthermore, the insertion and removal of the protrusion and bearing into the concavity of the element which is generally achieved by longitudinal displacement of the shafts, can be effected by means disposed outside the chamber.

Preferably, the bearing is a rotatably-mounted member whereby rolling contact is established between the element and bearing upon their initial engagement and prior to a gripping condition being reached.

Advantageously, the said concavity of the element is a circular hole the dimensioning of which is such, relative to the offset of the second shaft and the eccentricity of the bearing, that the centerline of the hole is coincident with that of the first shaft upon gripping engagement of the protrusion and bearing with the element. Such an arrangement ensures that a centrally-apertured element is held concentric with the first shaft during rotation of the latter.

The rotational drive means for relatively rotating the shafts preferably comprises a pneumatic actuator arranged to effect translational movement of a high helix screw that is constrained against rotation relative to the first shaft. The screw engages in a helix nut coupled to the second shaft whereby linear movement of the screw is translated into rotation of the second shaft.

A colleting spindle assembly embodying the invention and used in relation to vacuum deposition apparatus will now be described, by way of example, with reference to the accompanying drawings, in which:

Figures 1a and 1b are perspective views of the operative end of the colleting spindle assembly;

Figure 2 is a longitudinal section of the colleting spindle assembly; and

Figures 3a, 3b, 3c and 3d are an exploded view of the colleting spindle assembly illustrated in Figure 2.

The colleting spindle assembly to be described hereinafter is illustrated as applied to a vacuum deposition apparatus wherein substrate coating takes place in a high vacuum, elevated temperature environment. In the vacuum chamber a chassis transport platform moves a substrate mounting chassis into position in the chamber where the chassis is lifted from the platform and rotated during substrate coating. To describe the colleting spindle assembly, it will be sufficient to show only a portion of the chamber wall and the chassis hub.

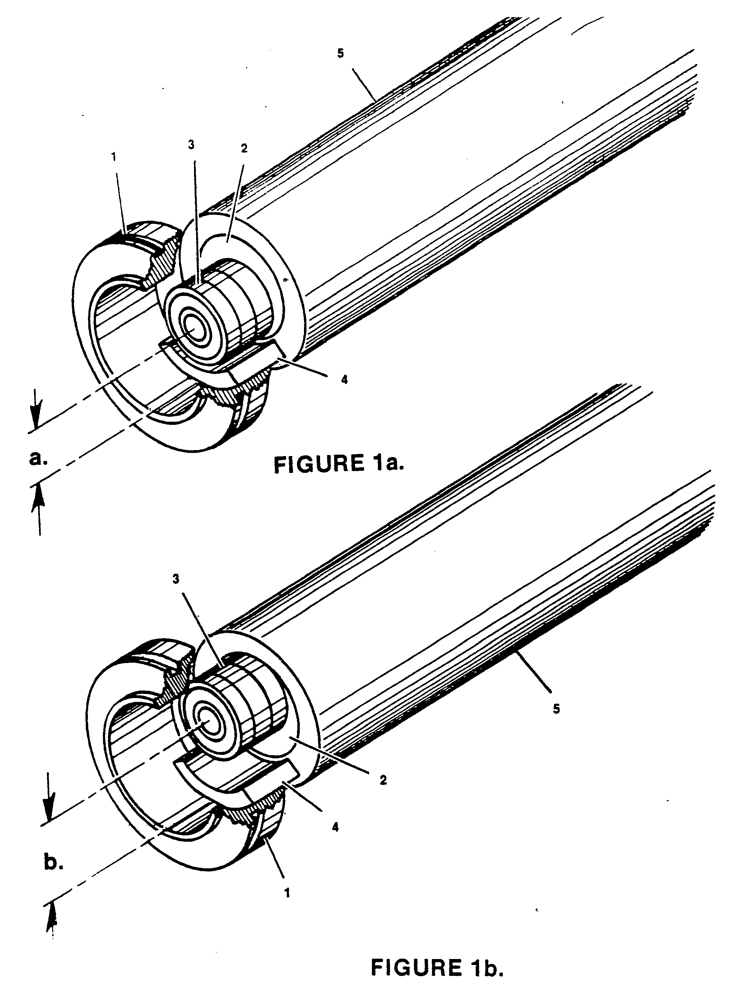

Referring now to Figures 1a and 1b, these Figures show the operative end portion of the colleting spindle assembly, this end portion being disposed within the vacuum chamber itself and including an extension 5 to the main spindle of the assembly (this spindle is not shown in Figures 1a, 1b). The spindle shaft extension 5 is provided with locater pad 4 protruding from a portion of the periphery of the face of the tip of the spindle shaft extension 5. A plunger shaft 2 is rotationally mounted within the spindle shaft extension 5 such that the plunger shaft's centreline is eccentric to the centreline of the spindle shaft extension. The plunger shaft 2 has an eccentrically mounted bearing 3 which protrudes from the end of the plunger shaft 2. Rotation of the plunger shaft 2 relative to the spindle shaft extension 5 varies the separation between the center of the eccentric bearing 3 and the outside surface of the locator pad 4 from a minimum distance "a" to a maximum distance "b".

The shafts 2, 5 are disposed horizontally. The plunger shaft 2 is first rotated to the orientation that minimizes the distance between the eccentric bearing 3 centreline and the outer surface of the locator pad 4, distance "a" as shown is Figure 1a. The shaft 5 is then rotated so that the locator pad 4 is face down.

Thus orientated, the protrusion 4 and bearing 3 are inserted into the central aperture of a substrate mounting chassis hub 1 to be picked up and rotated. Thereafter, the plunger shaft 2 is rotated relative to the spindle extension shaft 5 bringing the eccentric bearing 3 into rolling contact with the inner surface of the chassis hub 1. This action lifts the substrate mounting chassis (not shown) clear of the transport platform (not shown) and clamps the chassis hub 1 to the colleting spindle assembly. The eccentric bearing 3 is prevented from rotating over centre as the inner surface of the chassis hub 1 contacts the locating pad 4 and prevents any further rotation of the plunger shaft 2. The colleting spindle assembly is then rotated while a substrate coating process is carried out. At the completion of the processing, rotation of the assembly is stopped with the assembly in the same orientation as it was when first inserted in the chassis hub 1. The plunger shaft 2 is then rotated in the opposite direction as it was rotated for hub engagement, releasing the chassis hub 1 and positioning the substrate mounting chassis (not shown) back onto the transport platform (not shown).

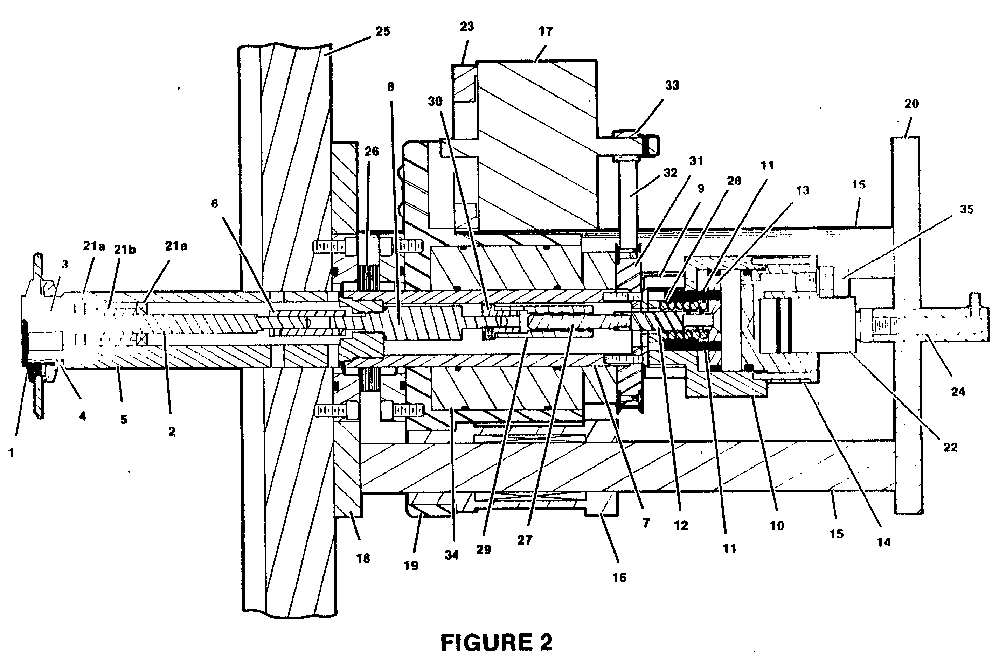

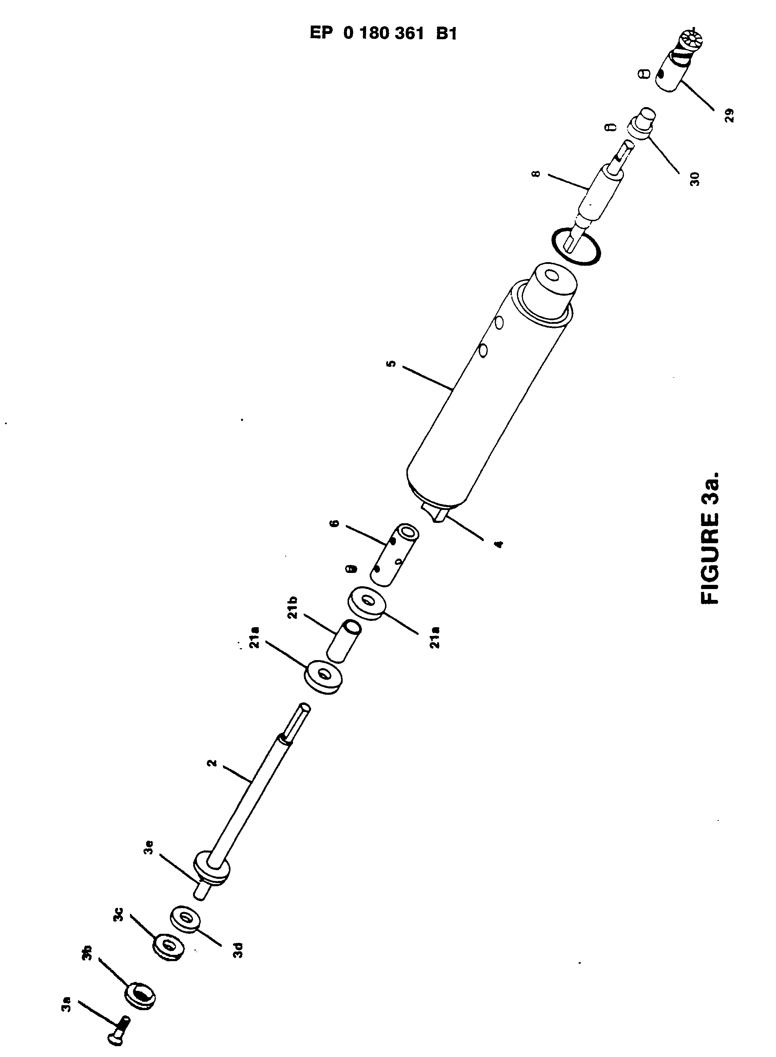

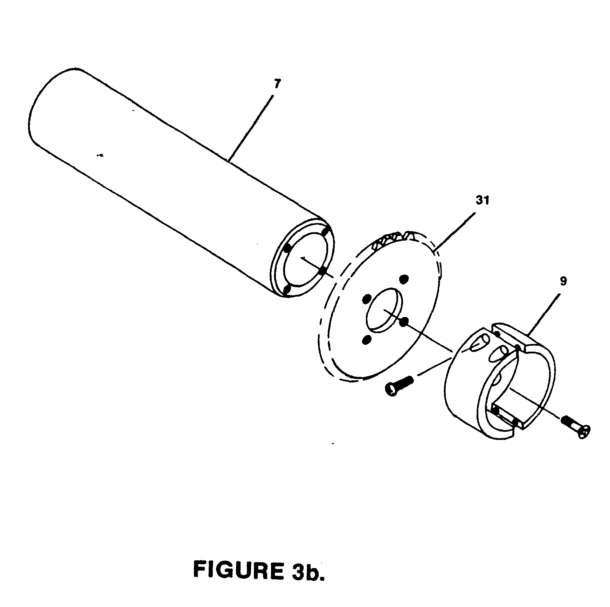

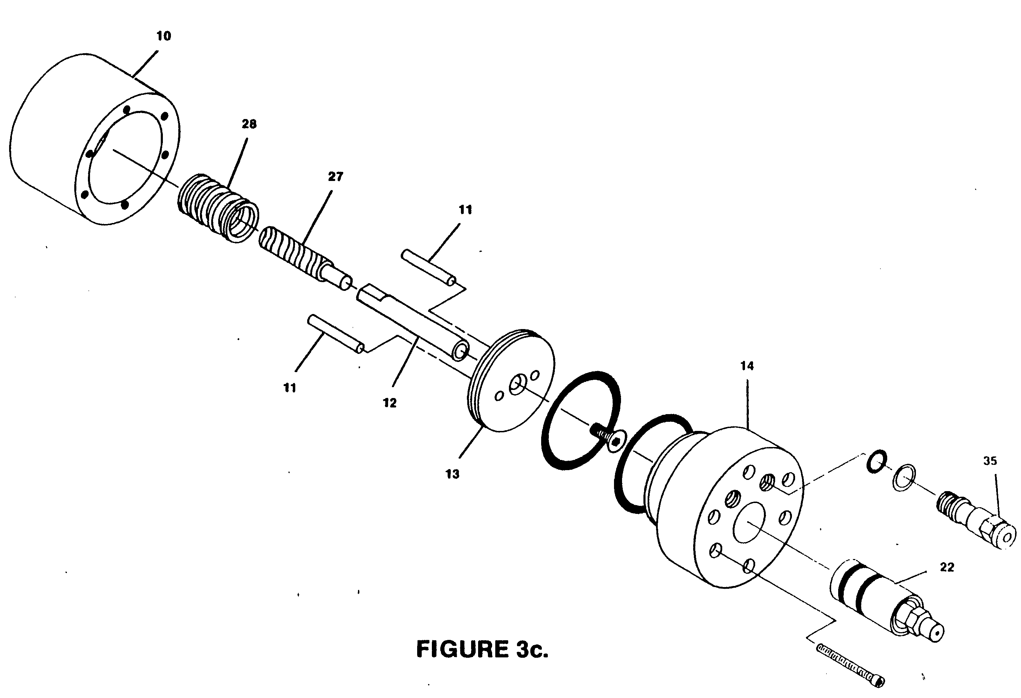

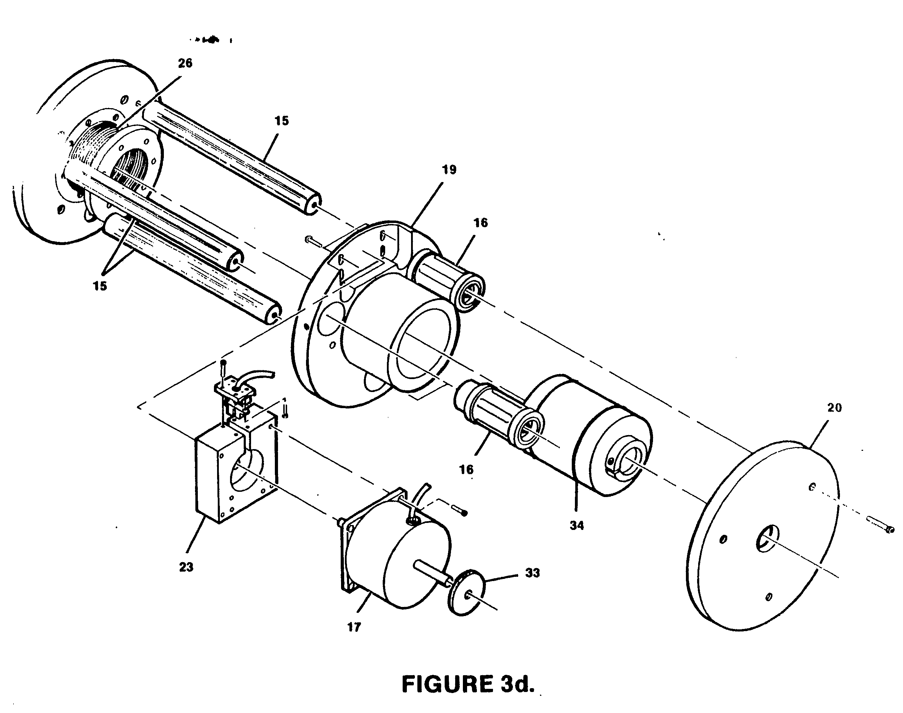

The detailed construction of the colleting spindle assembly is shown in Figures 2, 3a, 3b, 3c and 3d. Referring now to Figures 2, 3a, 3b, 3c and 3d, the eccentric bearing 3 comprises a bearing shield 3b and bearings 3c and 3d, and is mounted on a plunger shaft extension 3e by screw 3a. The plunger shaft 2 is eccentrically and rotationally mounted within the spindle shaft extension 5 by bearings 21a and a bearing separator 21b. The spindle shaft extension 5 passes through a bulkhead 25 of the vacuum chamber and is coupled to the main spindle shaft 7. A pulley 31 and a pneumatic actuator mounting collar 9 are fixably attached to the other end of the spindle shaft 7. The collar 9 mounts a pneumatic actuator comprising an actuator housing 10, a spring 28, a piston 13, a valve body 14, an air union 22 and air fittings 24 and 35. The actuator housing 10 includes two internal bores in which piston guide rods 11 are slideably mounted; the piston guide rods 11 not only guide the piston but also prevent rotation of the piston 13 relative to the spindle shaft 7. An extension rod 12 couples the piston 13 to a high helix screw 27; a flat-sided slot in the end of the extension rod 12 fits over the end of the helix screw 27 such that linear movement of the piston 13 results in linear movement of the helix screw 27. The helix screw 27 is engaged in a helix nut 29 such that linear movement of the helix screw 27 causes rotational motion of the helix nut 29 relative to the spindle shaft 7. The helix nut 29 is rigidly coupled to the plunger shaft 2 via a bushing 30, a ferrofluidic feed-through shaft 8 and a coupling 6.

The spindle shaft is mounted in a carriage plate 19 via a rotary vacuum seal 34 of the ferrofluidic type. Ferrofluidic seals are commercially available from the Ferrofluidics Corporation under the trade name Ferrofluidic (TM) seals. The carriage plate 19 is slideably mounted on shafts 15 by ball bushings 16 and is coupled to a front plate 18 by bellows 26. The front plate 18 is fixed to the vacuum chamber wall 25. A back plate 20 joins the rear ends of the shafts 15.

A stepping motor 17 is mounted on carriage plate 19 via a motor mount 23 and is coupled to the spindle shaft 7 by pulleys 33 and 31 via a belt 32. The spindle assembly is movably transversely to the chamber wall 25 by actuation of pneumatically-operated piston (not shown) coupled to the carriage plate 19.

Referring now to Figure 2, during operation the operative end of the assembly is first inserted in the chassis hub 1 by actuation of the pneumatic piston (not shown) coupled to the carriage plate 19. Proper orientation of the locator pad 4 is assured by operating the stepper motor 17 only in 200 nr increments (where n is a positive integer and r is the pulley ratio). Compressed air is then admitted to the valve body 14 forcing the piston 13 to move towards the spindle shaft 7 and compress the spring 28. The piston guide rods 11 prevent rotational motion of the piston 13 and hence movement of the piston results in linear motion of the helix screw 27. Linear motion of the helix screw 27 within the helix nut 29 results in rotational motion of the helix nut 29 relative to the spindle shaft 7. Rotational motion of the helix nut 29 results in rotation of the plunger shaft 2 relative to spindle shaft extension 5 to provide the required lifting and clamping action to engage the chassis hub 1. The plunger shaft 2 is coupled to the helix nut 29 via a ferrofluidic feed-through shaft 8 to maintain the vacuum during rotation of the plunger shaft 2. Once the chassis hub 1 is engaged, rotational motion is coupled to the substrate mounting chassis (not shown) from the stepper motor 17 via the pulleys 31 and 33 and the belt 32. The rotary vacuum seal 34 provides a liquid barrier to vacuum while permitting rotation of the spindle shaft 7. The bellows 26 provide vacuum seal while allowing the spindle assembly the linear motion necessary to insert or withdraw from the chassis hub 1. At the completion of the substrate processing, rotation of the chassis (not shown) is stopped and the pressure relieved from the piston 13. The compressed spring 28 then expands moving the helix screw 27 in the opposite direction causing the plunger shaft 2 to rotate thereby releasing the chassis hub 1.

**Claims**

1. A colleting spindle assembly for releasably engaging and coupling rotational motion to an element (1), characterized in that the assembly comprises:

a rotatably-mounted first shaft (5, 7) provided both with an internal cavity extending through the first shaft (5, 7) substantially parallel to the centreline of the latter, and with a protrusion (4) projecting out from a first end of the first shaft adjacent its periphery;

a second shaft (2) disposed within the cavity of the first shaft (5, 7), the centreline of the second shaft (2) being offset from the centreline of the first shaft (5, 7);

a bearing (3) eccentrically-mounted at one end of the second shaft (2), the bearing (3) extending out beyond said first end of the first shaft whereby to be jointly insertable with said protrusion (4) into a concavity of said element (1); and

rotatational drive means (10, 13, 27, 29) fixedly attached to the second end of the first shaft (5, 7), and coupled to the second shaft (2) for rotating the latter relative to the first shaft whereby to vary the distance between the centreline of the eccentrically-mounted bearing and the centreline of the first shaft (5, 7) in order to move the bearing (3) and protrusion (4) into and out of gripping engagement with the walls of the concavity of the element (1).

2. A colleting spindle assembly according to claim 1, wherein said first shaft comprises:

a spindle shaft (7) one end of which constitutes said second end of the first shaft, said rotational drive means (10, 13, 27, 29) being attached to and extending into said spindle shaft; and

a spindle shaft extension (5) one end of which constitutes the said first end of the first shaft and the other end of which is coupled to the spindle shaft (7), the said second shaft being disposed within the spindle shaft extension (5).

3. A colleting spindle assembly according to claim 2, wherein said rotational drive means comprises:

a piston assembly including a piston (13), piston guide means (11) and a piston rod (12), the piston rod (12) being fixedly attached to the centre of the piston (13) and extending perpendicular thereto, and said guide means (11) serving to guide and prevent rotation of the piston assembly relative to the spindle shaft (7);

a piston housing (10) including a base with a central aperture, said housing base being fixedly attached to said second end of the spindle shaft (7) and serving to mount the said piston guide means (11), and the piston rod (12) extending through said central aperture into the interior of the spindle shaft (7);

a high helix screw (27) diposed within the spindle shaft (7) and rigidly coupled to the piston rod (12) such that linear motion of the piston (13) produces linear motion of the helix screw (27);

a helix nut (29) rotatably mounted within the spindle shaft (7) and engaged with said helix screw (27), linear motion of said helix screw (27) being effective to impart rotational motion to the helix nut (29); and

coupling means arranged to couple rotational motion of the helix nut (29) to the said second shaft (2).

4. A colleting spindle assembly according to any one of the preceding claims, wherein said bearing (3) is rotatably mounted on said one end of the second shaft (2).

5. A colleting spindle assembly according to any one of the preceding claims, wherein the first shaft (5, 7) is mounted for longitudinal movement, the assembly further comprising an actuator for effecting longitudinal displacement of the first shaft (5, 7) whereby to insert and withdraw the said protrusion (4) and eccentrically-mounted bearing into and out of the concavity of said element (1).

6. A colleting spindle assembly according to any one of the preceding claims in combination with a said element (1) to be engaged thereby, the said concavity of the element being in the form of a circular recess or aperture the diameter of which is such that the centreline of said recess or aperture is coincident with that of the first shaft (5, 7) upon grippig engagement of the protrusion (4) and bearing (3) with the element (1).

7. A vacuum deposition chamber provided with a colleting spindle assembly according to any one of the preceding claims, the first and second shaft (5, 7, 2) extending horizontally through a wall (25) of the chamber in vacuum sealing relation therewith, the said first end of the first shaft (5, 7) being disposed within said chamber while the second end of the first shaft, together with said rotational drive means (10, 13, 27, 29), are disposed outside of the chamber.

**Patentansprüche**

1. Sammel-Spindelanordnung zum lösbaren Ineingriffbringen mit einem Element und zur Übertragung einer Drehbewegung auf dieses, gekennzeichnet durch:

eine drehbar angeordnete erste Welle (5, 7) mit einem sich durch die erste Welle (5, 7) im wesentlichen parallel zu ihrer Mittelachse erstreckenden inneren Hohlraum und einem von einem ersten Ende der ersten Welle von ihrem Umfang abstehenden Vorsprung (4), eine innerhalb des Hohlraumes der ersten Welle (5, 7) angeordnete zweite Welle (2), deren Mittelachse gegenüber der Mittelachse der ersten Welle (5, 7) versetzt ist,

ein an einem Ende der zweiten Welle (2) außermittig angeordnetes Lager (3), das sich über das erste Ende der ersten Welle hinaus erstreckt, so daß es zusammen mit dem Vorsprung (4) in eine konkave Ausnehmung in dem besagten Element (1) eingeführt werden kann, und

an dem zweiten Ende der ersten Welle (5, 7) befestigte und mit der zweiten Welle (2) gekoppelte Dreh-Antriebsmittel (10, 13, 27, 29), durch die zweite Welle (2) relativ zur ersten Welle in Rotation versetzt werden kann, wodurch sich der Abstand zwischen der Mittelachse des außermittig angeordneten Lagers und der Mittelachse der ersten Welle (5, 7) verändert und das Lager (3) und der Vorsprung (4) in Eingriff und außer Eingriff mit den Wandungen der konkaven Ausnehmung im Element (1) gebracht werden.

2. Sammel-Spindelanordnung nach Anspruch 1, dadurch gekennzeichnet, daß die erste Welle eine Spindelwelle (7), deren eines Ende das zweite Ende der ersten Welle darstellt, wobei die Dreh-Abtriebsmittel (10, 13, 27, 29) auf die Spindelwelle aufgesetzt sind und sich in diese hinein erstrecken, und eine Spindelwellen-Verlängerung (5) umfaßt, deren eines Ende das erste Ende der ersten Welle darstelle und deren anderes Ende mit der Spindelwelle (7) gekoppelt ist, wobei die zweite Welle innerhalb der Spindelwellen--Verlängerung (5) angeordnet ist.

3. Sammel-Spindelanordnung nach Anspruch 2, dadurch gekennzeichnet, daß die Drehantriebsmittel folgendes umfassen:

Eine Kolbengruppe, bestehend aus einem Kolben (13), Kolbenführungsmitteln (11) und einer Kolbenstange (12), wobei die Kolbenstange (12) fest mit dem Zentrum des Kolbens (13) verbunden ist und senkrecht zum Kolben verläuft und die Führungsmittel (11) dazu dienen, die Kolbengruppe zu führen und ihr Verdrehen relativ zur Spindelwelle zu verhindern,

ein Kolbengehäuse (10), das einen Sockel mit zentraler Öffnung aufweist, fest mit dem zweiten Ende der Spindelwelle (7) verbunden ist und zur Befestigung der Spindel-Führungsmittel (11) dient, wobei die Kolbenstange (12) sich durch die zentrale Öffnung in das Innere der Spindelwelle (7) hinein erstreckt,

eine innerhalb der Spindelwelle (7) angeordnete und mit der Kolbenstange (12) starr gekoppelte Schnecke (27) mit Außenverzahnung, so daß die Linearbewegung des Kolbens (13) eine Linearbewegung der Schnecke (27) erzeugt,

eine innerhalb der Spindelwelle (7) angeordnete und mit der Schnecke (27) in Eingriff stehende Schnecke (29) mit Innenverzahnung, so daß die Linearbewegung der Schnecke (27) in eine Drehbewegung der innenverzahnten Schnecke umgesetzt wird, und

Koppelmittel zur Übertragung der Drehbewegung der innenverzahnten Schnecke (29) auf die zweite Welle (2).

4. Sammel-Spindelanordnung nach einem der vorhergehenden Ansprüche, dadurch gekennzeichnet, daß das Lager (3) drehbar auf dem einen Ende der zweiten Welle (2) montiert ist.

5. Sammel-Spindelanordnung nach einem der vorhergehenden Ansprüche, dadurch gekennzeichnet, daß die erste Welle (5, 7) in Längsrichtung beweglich gelagert ist, wobei ferner ein Betätigungselement zur Auslösung einer Längsverschiebung der ersten Welle (5, 7) vorgesehen ist, wodurch der Vorsprung (4) und das außermittig angeordnete Lager in die konkave Ausnehmung des genannten Elementes (1) eingeführt und daraus zurückgezogen werden können.

6. Sammel-Spindelanordnung nach einem der vorhergehenden Ansprüche in Kombination mit einem damit in Eingriff zu bringenden Element (1), wobei die konkave Ausnehmung des Elementes die Form einer kreisförmigen Ausnehmung oder Öffnung mit einem solchen Durchmesser aufweist, daß die Mittelachse der Ausnehmung oder Öffnung in der Eingriffstellung des Vorsprunges (4) und des Lagers (3) mit dem Element (1) mit der Mittelachse der ersten Welle (5, 7) zusammenfällt.

7. Vakuum-Abscheidekammer mit einer Sammel-Spindelanordnung nach einem der vorhergehenden Ansprüche, wobei die erste und die zweite Welle (5, 7, 2) sich horizontal und vakuumdicht durch eine Wandung (25) der Kammer erstrecken und das erste Ende der ersten Welle (5, 7) sich innerhalb der Kammer befindet, während das zweite Ende der ersten Welle sowie die Dreh-Antriebsmittel (10, 13, 27, 29) sich außerhalb der Kammer befinden.

**Revendications**

1. Assemblage de mandrin de serrage destiné à venir au contact, avec possibilité de dégagement, d'un élément (1) et à transmettre un mouvement de rotation audit élément, caractérisé en ce que cet assemblage comporte:

un premier arbre (5, 7) monté avec possibilité de tourner pourvu à la fois d'une cavité interne s'étendant à travers le premier arbre (5, 7) pratiquement parallèle à la ligne d'axe de ce dernier, et d'une protubérance (4) faisant saillie à partir d'une première extrémité du premier arbre adjacente à sa périphérie;

un second arbre (2) disposé à l'intérieur de la cavité du premier arbre (5, 7), la ligne d'axe du second arbre (2) étant excentrée par rapport à la ligne d'axe du premier arbre (5, 7);

un dispositif d'appui (3) monté avec excentricité à une extrémité du second arbre (2), le dispositif d'appui (3) s'étendant à l'extérieur au-delà de ladite première extrémité du premier arbre de façon à pouvoir de ce fait être inséré conjointement avec ladite protubérance (4) dans un évidement concave dudit élément (1); et

des moyens (10, 13, 27, 29) d'entraînement rotatif fixés d'une manière rigide à la seconde extrémité du premier arbre (5, 7), et couplés au second arbre (2) de façon à faire tourner ce dernier par rapport au premier arbre de manière à faire varier de ce fait la distance entre l'axe du dispositif d'appui monté avec excentricité et l'axe du premier arbre (5, 7) afin d'amener le dispositif d'appui (3) et la protubérance (4) en contact de prise avec les parois de l'évidement concave de l'élément (1) et de les en dégager.

2. Assemblage de mandrin de serrage selon la revendication 1, dans lequel ledit premier arbre comporte:

un arbre (7) de mandrin dont une extrémité constitue ladite seconde extrémité du premier arbre, lesdits moyens (10, 13, 27, 29) d'entraînement rotatif étant fixés audit arbre de mandrin et s'étendant à l'intérieur de cet arbre de mandrin; et

un prolongement (5) d'arbre de mandrin dont une extrémité constitue ladite première extrémité du premier arbre et dont l'autre extrémité est couplée à l'arbre (7) de mandrin, ledit second arbre étant disposé à l'intérieur du prolongement (5) d'arbre de mandrin.

3. Assemblage de mandrin de serrage selon la revendication 2, dans lequel lesdits moyens d'entraînement rotatif comportent:

un assemblage formant piston qui comprend un piston (13), des moyens (11) de guidage du piston et une tige (12) de piston, la tige (12) de piston étant fixée d'une façon rigide au centre du piston (13) et s'étendant perpendiculairement à ce dernier, et, lesdits moyens (11) de guidage servant à guider et à empêcher la rotation de l'assemblage formant piston par rapport à l'arbre (7) de mandrin;

une enveloppe (10) de piston comprenant une base munie d'une ouverture centrale, ladite base de l'enveloppe étant fixée d'une façon rigide à ladite seconde extrémité de l'arbre (7) de mandrin et servant à monter lesdits moyens (11) de guidage du piston, et la tige (12) de piston s'étendant à travers ladite ouverture centrale jusque dans l'intérieur de l'arbre (7) de mandrin;

une vis (27) en hélice à grand pas disposée à l'intérieur de l'arbre (7) de mandrin et couplée d'une manière rigide à la tige (12) de piston de sorte qu'un mouvement linéaire du piston (13) produit un mouvement linéaire de la vis (27) en hélice;

un écrou (29) en hélice monté avec possibilité de tourner à l'intérieur de l'arbre (7) de mandrin et en prise avec ladite vis (27) en hélice, un mouvement linéaire de ladite vis (27) en hélice étant capable de communiquer un mouvement rotatif à l'écrou (29) en hélice; et

un moyen d'accouplement agencé de façon à transmettre le mouvement de rotation de l'écrou (29) en hélice audit second arbre (2).

4. Assemblage de mandrin de serrage selon l'une quelconque des revendications précédentes, dans lequel ledit dispositif (3) d'appui est monté avec possibilité de tourner sur ladite extrémité du second arbre (2).

5. Assemblage de mandrin de serrage selon l'une quelconque des revendications précédentes, dans lequel le premier arbre (5, 7) est monté de façon à pouvoir se déplacer longitudinalement, l'assemblage comportant en outre un dispositif de commande destiné à effectuer un déplacement longitudinal du premier arbre (5, 7) de manière, de ce fait, à insérer ladite protubérance (4) et ledit dispositif d'appui monté avec excentricité dans l'évidement concave dudit élément (1) et à les en extraire.

6. Assemblage de mandrin de serrage selon l'une quelconque des revendications précédentes en combinaison avec un élément (1) précité destiné à être enclenché par cet assemblage, ledit évidement concave de cet élément ayant la forme d'une niche ou d'une ouverture circulaire dont le diamètre est tel que l'axe de ladite niche ou ouverture coïncide avec celui du premier arbre (5, 7) dès que la protubérance (4) et le dispositif d'appui (3) sont en contact de prise avec l'élément (1).

7. Chambre de dépôt sous vide pourvue d'un assemblage de mandrin de serrage selon l'une quelconque des revendications précédentes, les premier et second arbres (5, 7, 2) s'étendant horizontalement à travers une paroi (25) de la chambre en liaison étanche au vide avec cette paroi, ladite première extrémité du premier arbre (5, 7) étant disposée à l'intérieur de ladite chambre tandis que la seconde extrémité du premier arbre, ainsi que lesdits moyens (10, 13, 27, 29) entraînement rotatif, sont disposés à l'extérieure de la chambre.

FIGURE 1a.

FIGURE 1b.

**FIGURE 2**

FIGURE 3a.

**FIGURE 3b.**

**FIGURE 3c.**

FIGURE 3d.